**Europäisches Patentamt**

**European Patent Office**

**Office européen des brevets**

(19)

(11) Numéro de publication : **0 068 059**
**B1**

# (12) FASCICULE DE BREVET EUROPÉEN

(45) Date de publication du fascicule du brevet :
**20.02.85**

(51) Int. Cl.⁴ : **H 03 K 19/21// H03M13/00**

(21) Numéro de dépôt : **81430020.8**

(22) Date de dépôt : **25.06.81**

(54) **Circuit ou exclusif et circuit de vérification de parité l'incorporant.**

(43) Date de publication de la demande :
**05.01.83 Bulletin 83/01**

(45) Mention de la délivrance du brevet :
**20.02.85 Bulletin 85/08**

(84) Etats contractants désignés :
**DE FR GB**

(56) Documents cités :
**FR-A- 2 296 969**
**IBM TECHNICAL DISCLOSURE BULLETIN, vol. 23,
no. 5, octobre 1980, NEW YORK (US), DENNISON et
al.: "Bipolar selector functions", pages 1913-1914**
**IBM TECHNICAL DISCLOSURE BULLETIN, vol. 18,
no. 9, février 1976, NEW YORK (US), TING: "Logical
circuit", page 2882**
**IBM TECHNICAL DISCLOSURE BULLETIN, vol. 7, no.
6, novembre 1964, NEW YORK (US), HACK: "Even-
Odd circuit", pages 425-426**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Beranger, Hervé**
**13 rue A. Barbier**
**F-77300 Fontainebleau (FR)**
Inventeur : **Brunin, Armand**
**61, allée de Bretagne**
**F-77350 Le Mee/Seine (FR)**

(74) Mandataire : **Lattard, Nicole**
**Compagnie IBM France Département de Propriété
Industrielle**
**F-06610 La Gaude (FR)**

# 0 068 059

## Description

La présente invention concerne la réalisation de circuits OU exclusifs et l'utilisation de ces circuits pour réaliser un circuit de vérification de parité.

La vérification de parité est un moyen classique utilisé dans les systèmes de traitement de données numériques pour en contrôler le bon fonctionnement. Dans la majorité des systèmes de traitement de données, les bits sont groupés en octets et un bit de parité est ajouté aux 8 bits de l'octet pour que l'ensemble des 9 bits comprenne toujours un nombre pair ou impair de bits 1, suivant la convention retenue. La vérification de parité consiste à contrôler la parité des 9 bits après toute opération de transfert de données, de lecture de mémoire, etc...

En conséquence, dans les systèmes importants, le nombre de ces opérations de contrôle peut être très grand, et il faut qu'elles soient réalisées le plus rapidement possible pour ne pas ralentir le traitement des données. De plus, il ne faut pas que ces circuits tiennent trop de place par rapport à l'ensemble du système de traitement de données.

### Description de l'Art Antérieur

Les circuits de vérification de parité comprennent généralement des circuits OU exclusifs ou des circuits OU exclusifs complémentaires, tel que décrit dans l'article IBM Technical Disclosure Bulletin Vol. 18, No. 5, octobre 1975, pages 1411-1412.

Le circuit de vérification de parité décrit dans cet article est réalisé avec quatre étages de circuits OU exclusifs complémentaires à deux entrées. Du fait que chaque étage introduit un retard, l'opération de vérification dans ce type de circuit est relativement longue.

On peut aussi utiliser un réseau de circuits OU exclusifs à trois entrées, comme décrit dans le brevet FR-A-2 296 969 déposé par la demanderesse en France, le 31 décembre 1974. Cependant, les circuits OU exclusifs à trois entrées nécessitent beaucoup d'éléments. En effet, la fonction OU exclusif $\oplus$ de trois entrées ABC qui s'écrit :

$$A \oplus B \oplus C = A\bar{B}\bar{C} + \bar{A}BC + \bar{A}B\bar{C} + ABC$$

nécessite pour sa réalisation quatre circuits ET et quatre circuits OU et des circuits de complémentation, ce qui prend beaucoup de place. En conséquence, la suppression d'un étage de logique se fait aux dépens d'une augmentation de l'encombrement du circuit.

### Résumé de l'Invention

En conséquence, un objet de la présente demande est de réaliser un circuit OU exclusif à au moins deux entrées, qui a des caractéristiques de fonctionnement améliorées.

Un autre objet de la présente invention est de réaliser à l'aide de circuits OU exclusifs conformes à l'objet précédent, un circuit de vérification de parité qui ne nécessite que trois étages de circuits logiques.

Le circuit OU exclusif à deux entrées conforme à la présente invention comporte deux bornes d'entrée recevant des signaux binaires A et B, et une borne de sortie sur laquelle est obtenu le signal représentant le résultat de la fonction OU exclusif $A \oplus B$. Il comprend un générateur de tension de référence ; un premier circuit fournissant la fonction logique $\bar{A}\bar{B}$ comprenant un premier et un second transistors ayant leurs émetteurs connectés à la sortie du générateur de tension de référence, leurs collecteurs connectés en commun, et une première et une seconde diodes, la première diode ayant une électrode connectée à la base du premier transistor et l'autre connectée à une des bornes d'entrée, la seconde diode ayant une électrode connectée à la base du second transistor, et l'autre électrode connectée à l'autre borne d'entrée ; un second circuit réalisant la fonction logique AB et un troisième circuit ayant deux entrées, chacune étant connectée aux sorties des premier et second circuits, et une sortie sur laquelle est obtenue la fonction :

$$A \oplus B = \overline{AB + \bar{A}\bar{B}}$$

Le circuit de vérification de parité pour générer l'indication de parité d'un mot d'entrée de 9 bits comprend : un premier étage formé de quatre circuits OU exclusifs à deux entrées tels que décrit précédemment, chaque entrée recevant un bit du mot, et un générateur de valeur vraie/complémentaire recevant le bit restant du mot d'entrée et fournissant sur une première sortie la valeur vraie de ce bit et sur une seconde sortie le complément de ce bit ; un second étage comprenant deux moyens de comparaison, inversant le résultat de la comparaison, le premier comparant les sorties des deux premier et second circuits OU exclusifs, et le second les sorties des troisième et quatrième circuits OU exclusifs, et un troisième étage générant l'indication de parité à partir des sorties des moyens de comparaison et de valeurs vraie et complémentaire fournies par le générateur de valeur vraie/complémentaire.

2

## Brève Description des Figures

La figure 1 représente un circuit OU exclusif à deux entrées conforme à la présente invention.

La figure 2 représente la réalisation d'un circuit OU exclusif à trois entrées réalisé conformément au principe utilisé dans le circuit de la figure 1.

La figure 3 représente le schéma d'un circuit de vérification de parité incorporant des circuits OU exclusifs conformément au principe de la présente invention.

La figure 4 représente le schéma d'un circuit qui peut être utilisé comme circuits 35 et 36 sur la figure 3.

La figure 5 représente le schéma d'un circuit qui peut être utilisé comme circuit 37 sur la figure 3.

La figure 6 représente le schéma d'un générateur de valeurs vraie/complémentaire qui peut être utilisé comme circuit 32 sur la figure 3.

## Description Détaillée de l'Invention

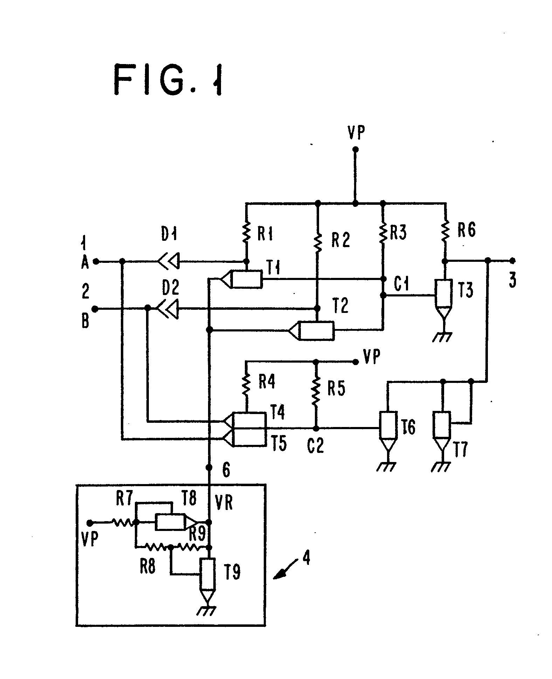

Le circuit OU exclusif de la figure 1 comprend deux premiers transistors T1 et T2 et deux diodes de Schottky D1 et D2 qui, à partir des signaux A et B sur les entrées 1 et 2 fournissent sur le nœud C1 le signal binaire résultant de la fonction logique $\bar{A}B$ et deux autres transistors T4 et T5 fournissant au nœud C2 le signal binaire résultant de la fonction logique AB. Les signaux aux nœuds C1 et C2 sont appliqués à un circuit comprenant deux transistors T3 et T6, et fournissant sur la sortie 3 le signal binaire résultant de la fonction logique

$$\overline{A\bar{B} + AB}$$

qui est égal à $A\bar{B} + \bar{A}B$ soit la fonction OU exclusif $A \oplus B$.

Les signaux d'entrée A et B sont appliqués d'une part aux cathodes des diodes D1 et D2 respectivement. Les anodes des diodes sont connectées aux bases des transistors T1 et T2. Les bases des transistors T1 et T2 sont aussi connectées à une tension de polarisation VP par des résistances R1 et R2 respectivement. Les émetteurs des transistors T1 et T2 sont reliés à un générateur de tension de référence 4 qui fournit une tension VR de valeur inférieure à VP. Les collecteurs sont connectés en commun au point C1 relié à la tension de polarisation VP par une résistance R3.

D'autre part, ces signaux d'entrée sont appliqués aux émetteurs des transistors T4 et T5 dont les bases sont connectées en commun à la tension VP par une résistance R4. Les collecteurs communs sont reliés au nœud C2 connecté à la tension VP par une résistance R5.

Les nœuds C1 et C2 sont reliés aux bases des transistors T3 et T6 respectivement. Les émetteurs de ces transistors sont mis à la masse et les collecteurs sont connectés en commun à la sortie 3. Une résistance R6 connecte les collecteurs des transistors T3 et T6 à la tension VP. Un transistor monté en diode T7 ayant sa base et son collecteur connectés en commun à la sortie 3 et son émetteur mis à la masse permet de réduire le temps de transition du front descendant du signal de sortie.

Un générateur de tension de référence qui peut être utilisé est représenté à titre d'exemple sur la figure 1. Il comprend deux transistors T8 et T9 et trois résistances R7, R8 et R9. T8 est monté en diode, T9 est monté en amplificateur avec émetteur à la masse, et contre-réaction collecteur-base. Le collecteur et la base du transistor T8 sont connectés ensemble à la tension VP par la résistance R7, l'émetteur de ce transistor est connecté à la sortie 6 du générateur sur laquelle est engendrée la tension VR. Les résistances R8 et R9 sont montées en série entre les collecteurs des transistors T8 et T9. Le point commun de ces résistances est relié à la base du transistor T9, et le collecteur de ce transistor est connecté à la borne 6.

La tension VR sur la borne 6 peut donc s'exprimer de la façon suivante :

$$VR = VBE\ (T9) - R9\ VBE\ (T8)/(R8 + R9)$$

VBE (T9) et VBE (T8) étant les tensions base-émetteur des transistors T9 et T8 respectivement.

Dans un mode de réalisation préféré les résistances ont les valeurs suivantes :

R1 = R2 = 13 kilo-ohms
R3 = 7,5 kilo-ohms
R4 = 15 kilo-ohms
R5 = R9 = 11 kilo-ohms
R6 = 8 kilo-ohms
R7 = 5 kilo-ohms
R8 = 6 kilo-ohms et
VP = 1,7 volts
VR = 0,35 volt

Dans le circuit de la figure 1, on peut voir qu'au nœud C1 est engendré un signal binaire au niveau

3

bas lorsque les deux entrées sont à 1 ou que l'une ou l'autre des entrées est à 1 et qu'un niveau haut est engendré lorsque les deux entrées sont à 0. En conséquence, le niveau logique en C1 représente le résultat de la fonction $\bar{A}\bar{B}$.

Au nœud C2 est engendré un signal binaire au niveau haut lorsque A et B sont à 1 et au niveau bas dans le cas contraire : A et B à 0 ou A = 0 B = 1 ou A = 1, B = 0. En conséquence, le niveau logique en C2 représente le résultat de la fonction AB.

$$A = 1 \quad B = 1$$

Les diodes D1 et D2 sont bloquées, les transistors T1 et T2 sont conducteurs, le niveau en C1 est bas. Les transistors T4 et T5 sont bloqués le niveau en C2 est haut.

C1 étant au niveau bas et C2 au niveau haut, le transistor T3 est bloqué, et le transistor T6 est conducteur donc la sortie 3 est au niveau bas représentant un 0 soit $A \oplus B$.

$$A = 0 \quad B = 0$$

Les diodes D1 et D2 sont conductrices, et les transistors T1 et T2 sont bloqués, le niveau en C1 est haut. Les transistors T4 et T5 sont conducteurs le niveau en C2 est bas.

Dans ces conditions, le transistor T3 est conducteur et le transistor T6 est bloqué, donc la sortie 3 est au niveau bas représentant un 0 soit $A \oplus B$.

$$A = 1 \quad B = 0$$

La diode D1 est bloquée, le transistor T1 est conducteur. La diode D2 est conductrice, le transistor T2 est bloqué, le niveau en C1 est bas. Le transistor T4 est bloqué, le transistor T5 est conducteur, le niveau en C2 est bas.

Dans ces conditions les transistors T3 et T6 sont bloqués, donc la sortie 3 est au niveau haut représentant un 1 soit $A \oplus B$.

$$A = 0 \quad B = 1.$$

La diode D1 est conductrice, le transistor T1 est bloqué. La diode D2 est bloquée le transistor T2 est conducteur. Le niveau en C1 est bas. Le transistor T4 est conducteur, et le transistor T5 est bloqué, le niveau en C2 est bas.

Dans ces conditions, les transistors T3 et T6 sont bloqués, donc la sortie 3 est au niveau haut représentant un 1 soit $A \oplus B$.

L'avantage du circuit représenté sur la figure 1 par rapport aux circuits classiques les plus simples dans lesquels une comparaison des deux entrées est faite par l'intermédiaire de transistors ou de diodes à barrière de Schottky, est que le seuil sur l'une des entrées ne dépend pas du niveau continu sur l'autre entrée. Ceci est un avantage très important car il est connu que dans les circuits intégrés de la famille T2L le niveau bas continu peut varier de 0,2 V à 0,4 V suivant la charge du circuit et le procédé d'intégration. Ceci a des répercussions néfastes sur les retards introduits par le circuit, du fait que le niveaux sur les deux entrées sont indépendants. Cet inconvénient n'existe plus dans le circuit proposé où la comparaison est faite par rapport à la tension de référence. Aussi, puisque le seuil sur l'une des entrées ne dépend pas du niveau continu de l'autre entrée mais d'une tension de référence, l'immunité à un bruit d'entrée est amélioré.

De plus, dans ce circuit, il n'est pas nécessaire d'avoir disponibles les compléments des signaux d'entrée, et le nombre des circuits logiques élémentaires est très réduit par rapport aux circuits OU exclusifs de l'art antérieur réalisés à base de circuits logiques élémentaires qui nécessitent quatre portes NON ET.

De plus, la puissance dissipée par ce circuit est faible, de l'ordre de 0,8 mW dans le circuit OU exclusif proprement dit, et 0,18 mW dans le générateur de référence. Le délai introduit par le circuit est faible, de l'ordre de 1,7 ns. Une densité élevée peut être obtenue, surtout si plusieurs circuits OU exclusifs peuvent partager la même référence.

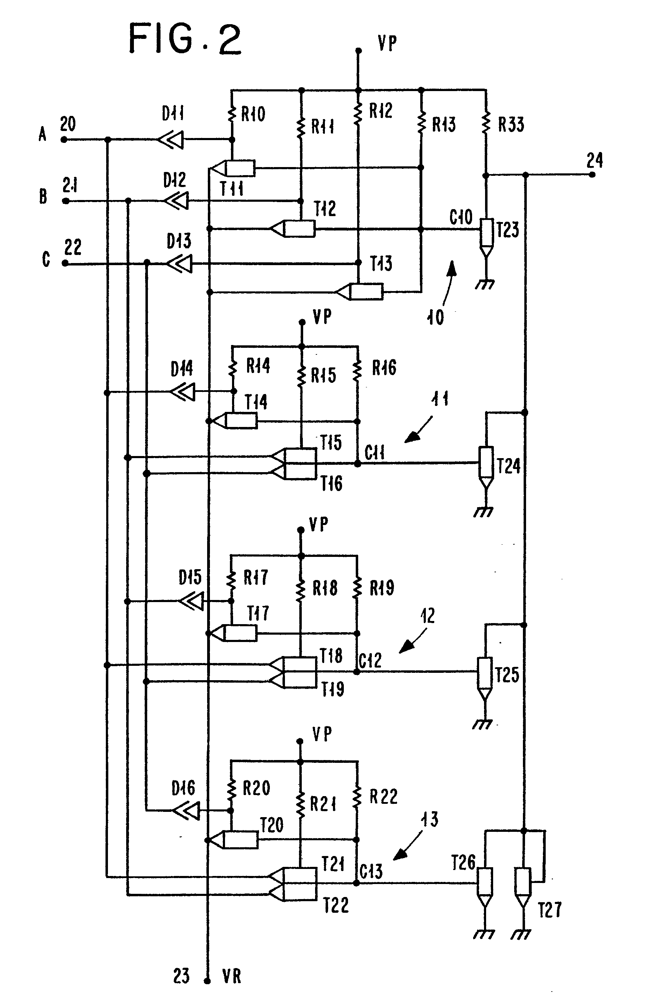

De plus, le principe de ce circuit peut être étendu à la réalisation d'un dispositif à plus de deux entrées. Un exemple de circuit à trois entrées est représenté sur la figure 2.

Le circuit de la figure 2 réalise la fonction OU exclusif $A \oplus B \oplus C$, conformément à l'expression :

$$A \oplus B \oplus C = \overline{\overline{\bar{A}\bar{B}\bar{C} + \bar{A}BC + A\bar{B}C + AB\bar{C}}}$$

Il comprend des circuits 10, 11, 12 et 13 recevant les signaux d'entrées ABC et fournissant les résultats des fonctions $\bar{A}\bar{B}\bar{C}$, $\bar{A}BC$, $A\bar{B}C$ et $AB\bar{C}$ respectivement. Les circuits 11, 12 et 13 sont identiques, leurs entrées recevant différents signaux.

Le circuit 10 comprend trois diodes D11, D12 et D13 dont les cathodes sont connectées aux entrées 20, 21 et 22 du circuit sur lesquelles sont appliqués les signaux ABC respectivement. Les anodes sont reliées aux bases des transistors T11, T12 et T13 respectivement, dont les émetteurs sont reliés en commun à la borne 23 mise à la tension de référence VR. Les bases des transistors T11, T12 et T13 sont reliées à la tension de polarisation VP par des résistances R10, R11 et R12 et leurs collecteurs sont connectés au point C10 relié à la tension VP par la résistance R13.

Du fait de cette disposition on peut voir qu'au point C10 est généré un niveau logique qui représente le résultat de la fonction logique $\overline{A}\overline{B}\overline{C}$. En effet, si A, B et C sont à 0, les diodes D11, D12 et D13 sont conductrices. Les transistors sont donc bloqués et le nœud C10 est au niveau haut. Si les trois entrées sont à 1, les diodes sont bloquées et les transistors sont conducteurs, donc le niveau en C10 est bas. Si une (ou deux) entrée(s) est(sont) à 0, l'autre (ou les deux autres) est(sont) à 1, au moins un des transistors est conducteur, et le niveau au nœud C10 est bas.

Le circuit 11 comprend une diode D14 ayant sa cathode connectée à l'entrée 20 recevant le signal 1, son anode connectée à la base du transistor T14. L'émetteur du transistor T14 est mis à la tension VR et sa base est connectée à la tension de polarisation VP par une résistance R14. Deux transistors T15 et T16 ont leurs émetteurs connectés respectivement aux entrées 21 et 22 (A et B), leurs bases connectées à la tension VP par une résistance R15 et leurs collecteurs connectés au commun avec celui du transistor T14 au nœud C11, et par l'intermédiaire de la résistance R16 à la tension VP. Ce circuit fournit au nœud C11 le résultat de la fonction logique $\overline{A}BC$. En effet le niveau en C11 n'est haut que si A = 0, B = 1, et C = 1. Dans ce cas, la diode D14 est conductrice et les trois transistors T14, T15 et T16 sont bloqués, et le niveau en C11 est haut. Dans tous les autres cas, au moins un des transistors est conducteur et le niveau en C11 est bas.

Les autres circuits 12 et 13 sont réalisés de la même façon avec des diodes D15 et D16 correspondant à la diode D14 des transistors T17, T18, T19 et T20, T21, et T22 correspondant aux transistors T14, T15 et T16 respectivement et des résistances R17, R18 et R19 et R20, R21 et R22 correspondant aux résistances R14, R15 et R16.

Dans le circuit 12, la cathode de la diode D15 est reliée à l'entrée 21 (B) et les émetteurs des transistors T18 et T19 sont connectés aux entrées 20 et 22 (A, C), donc en C12 est fourni le résultat de la fonction logique $A\overline{B}C$.

Dans le circuit 13, la cathode de D16 est connectée à l'entrée 22 (C) et les émetteurs des transistors T21 et T22 sont connectés aux entrées 20 et 22 (A et B) donc en C13 est fourni le résultat de la fonction logique $AB\overline{C}$.

Les nœuds C10, C11, C12 et C13 sont connectés aux bases des transistors T23, T24, T25 et T26 dont les émetteurs sont mis à la masse, et les collecteurs reliés en commun à la sortie 24, et à la tension VP par une résistance R33. En conséquence, ces quatre transistors, réalisent et fournissent sur la sortie 24 le résultat de l'opération :

$$\overline{\overline{A}\overline{B}\overline{C} + \overline{A}BC + A\overline{B}C + AB\overline{C}} = A \oplus B \oplus C$$

Le transistor monté en diode T27 ayant son collecteur et sa base reliés aux collecteurs communs des transistors T23 à T26 et son émetteur mis à la masse à la même fonction que le transistor T7 sur la figure 1. T27 permet de réduire le temps de la transition descendante.

Dans un mode de réalisation préféré, les résistances ont les valeurs suivantes :

R10 = R11 = R12 = 15 kilo-ohms
R13 = 11 kilo-ohms
R33 = 8 kilo-ohms
R14 = R17 = R20 = 20 kilo-ohms
R15 = R18 = R21 = 23 kilo-ohms
R16 = R19 = R22 = 17 kilo-ohms

Les résistances ont des valeurs plus faibles dans le circuit 10 que dans les trois autres circuits 11, 12 et 13 pour obtenir des temps de retard égaux dans les quatre circuits.

La tension de référence doit avoir une valeur telle qu'elle permette le blocage des transistors d'entré T11, T12, T13, T14, T17, T20 et le blocage des transistors de sortie T23, T24, T25, T26 suivant l'état des signaux d'entrée. Dans un mode de réalisation préféré elle est choisie égale à 0,35 volt.

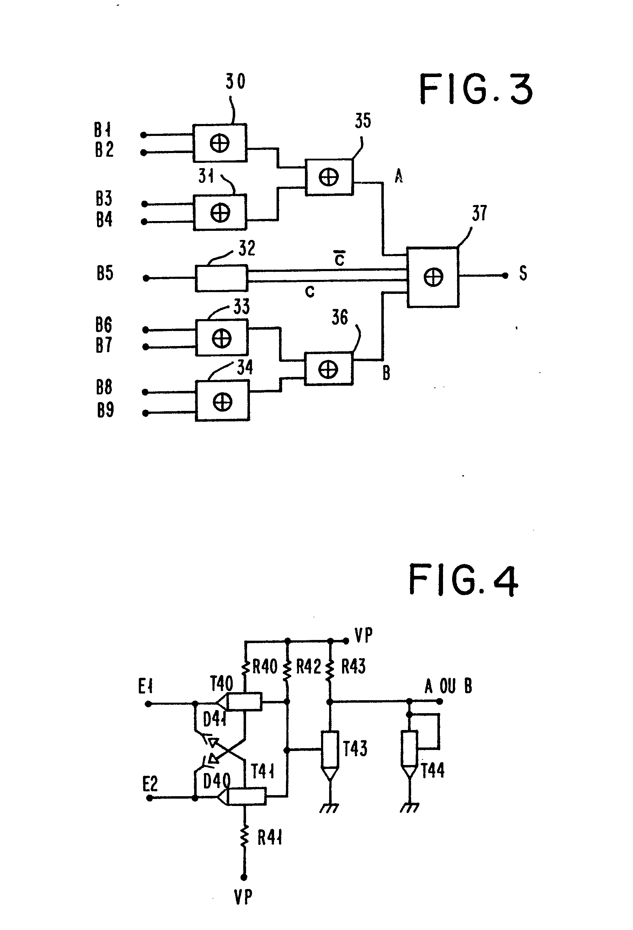

On va maintenant décrire en référence à la figure 3, un circuit de vérification de parité réalisé conformément au principe de la présente invention.

Ce circuit comprend un premier étage de logique recevant les 9 bits du mot dont la parité est à vérifier. Cet étage est constitué par quatre circuits OU exclusifs 30, 31, et 33, 34 réalisés conformément au circuit OU exclusif de la présente invention représenté sur la figure 1, et par le circuit 32. Le circuit 30 reçoit en entrées les bits 1 et 2 : B1 et B2, le circuit 31 les bits 3 et 4 : B3 et B4, le circuit 33 les bits 6 et 7 : B6 et B7, et le circuit 34 les bits 8 et 9 : B8 et B9. Le circuit 32 dans cet étage est un circuit générateur de valeur vraie/complémentaire qui reçoit le bit 5 : B5 et fournit sur ses sorties la valeur vraie de ce bit : C et la valeur complémentaire : $\overline{C}$.

Le deuxième étage de logique comprend deux circuits OU exclusifs 35 et 36, qui reçoivent en entrées les sorties de 30 et 31 et les sorties de 33 et 34 respectivement. Les sorties de 35 et 36 sont référencées A et B respectivement. Dans un mode de réalisation préféré ces circuits OU exclusifs sont de simples circuits de comparaison fournissant un signal « 0 » lorsque les entrées sont égales et un signal « 1 » dans le cas contraire, comme cela sera représenté sur la figure 4.

Le dernier étage comprend un circuit OU exclusif 37 qui reçoit en entrées les sorties des circuits 35 et 36 et les valeurs vraie et complémentaire C et C̄ venant de 32.

Des circuits qui pourront être utilisés comme circuits 35 et 36 sont représentés sur la figure 4. Il est bien entendu qu'ils pourraient être constitués de circuits tels que représentés sur la figure 1, mais cet étage n'étant pas accessible de l'extérieur, les niveaux d'entrée sont bien définis et en conséquence ces circuits 35 et 36 n'ont pas besoin de présenter les caractéristiques d'immunité au bruit des circuits de l'étage d'entrée accessibles de l'extérieur. En conséquence, on peut choisir des circuits 35 et 36 extrêmement simples et rapides.

Un circuit type 35 ou 36 est donc représenté sur la figure 4. Il comporte deux entrées E1 et E2, qui seront connectées aux sorties de 30 et 31 ou de 33 et 34 suivant qu'il s'agit du circuit 35 ou 36 respectivement.

Il comprend deux transistors T40 et T41 ayant leurs émetteurs connectés aux entrées E1 et E2, leurs bases connectées à la tension de polarisation VP par des résistances R40 et R41, leurs collecteurs connectés en commun par une résistance R42 à la tension VP. La base du transistor T40 est connectée à l'émetteur de T41 par une diode de Schottky D40 dont l'anode est connectée à la base et la cathode à l'émetteur. De même la base du transistor T41 est connectée à l'émetteur du transistor T40 par une diode de Schottky D41 dont l'anode est connectée à la base, et la cathode est connectée à l'émetteur.

Un transistor inverseur T43 a sa base connectée aux collecteurs communs, son émetteur mis à la masse, son collecteur connecté par une résistance R43 à la tension de polarisation VP.

La sortie A ou B du circuit est prise au collecteur du transistor T43.

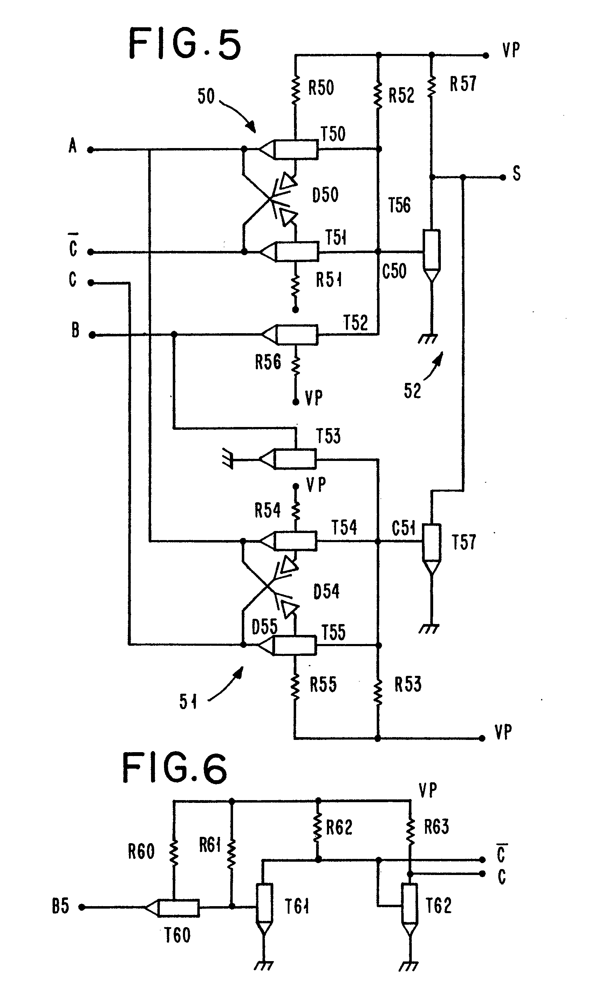

Un transistor T44 monté en diode sert à limiter le niveau haut de sortie. Ce transistor a son émetteur connecté à la masse, son collecteur relié à sa base et connecté au collecteur du transistor T43. Ce transistor doit être supprimé dans le circuit utilisé comme circuit 36, du fait de la disposition du circuit du dernier étage 37. Ceci sera évident, compte-tenu de la configuration du circuit 37 représenté sur la figure 5. Dans le circuit 35 par contre, ce transistor T44 permet de réduire le temps de la transition descendante.

Le fonctionnement du circuit de la figure 4 est le suivant : lorsque les niveaux sur les entrées E1 et E2 sont identiques, les transistors T40 et T42 sont bloqués. En conséquence le niveau sur la base du transistor T43 est haut et ce transistor est conducteur, le niveau en sortie est bas. Si les niveaux ou les entrées sont différents, l'un des transistors T40 ou T41 est conducteur, et le transistor T43 est bloqué, le niveau de sortie est haut.

Ce circuit réalise bien la fonction OU exclusif des deux entrées sur E1 et E2.

On va maintenant décrire en référence à la figure 5, un circuit qui peut être utilisé comme circuit 37. On pourrait bien entendu utiliser le circuit de la figure 2, mais pour les mêmes raisons que celles exposées précédemment, il n'est pas nécessaire d'utiliser un circuit présentant une bonne immunité au bruit, puisque les entrées A, C, C̄ et B de ce circuit ne viennent pas de l'extérieur et en conséquence ont des niveaux bien définis.

Il comprend un premier circuit 50 recevant les signaux A, B et C̄ et fournissant sur le nœud C50 un signal représentant le résultat de la fonction

$$B \, \overline{(A \oplus \bar{C})}$$

et un second circuit 51 recevant les signaux A, B et C et fournissant sur le nœud C51 un signal représentant le résultat de la fonction

$$\bar{B} \, \overline{(A \oplus C)}$$

Un circuit de sortie 52 réalise la fonction :

$$\overline{B \, \overline{(A \oplus \bar{C})} + \bar{B} \, \overline{(A \oplus C)}}$$

soit

$$\overline{B \, (\bar{A}C + A\bar{C}) + \bar{B} \, (\bar{A}\bar{C} + AC)} = \overline{B\bar{A}C + BA\bar{C} + \bar{A}\bar{B}\bar{C} + \bar{B}AC} = A\bar{B}\bar{C} + \bar{A}\bar{B}C + ABC + \bar{A}B\bar{C} = A \oplus B \oplus C$$

Le circuit 50 comprend trois transistors, T50, T51, T52 et deux diodes de Schottky D50 et D51. Les transistors T50 et T51 associés aux diodes D50 et D51 et aux résistances R50, R51 et R52 sont montés de la même façon que le circuit de la figure 4 : le transistor T50 recevant sur son émetteur le signal A, le transistor T51 le signal C̄.

En conséquence il fournit au nœud C50 pris aux collecteurs communs des transistors T50 et T51 le complément de la fonction A ⊕ C̄.

Le transistor T52 recevant sur son émetteur le signal B, et ayant sa base connectée par la résistance

6

R56 à la tension de polarisation VP, a son collecteur connecté au nœud C50. Il permet d'obtenir à ce nœud le résultat de la fonction

$$\overline{B \; \overline{(A \oplus \bar{C})}}$$

En effet si B = 0 le transistor T52 est conducteur et la tension au nœud C50 est basse quel que soit le résultat

$$\overline{A \oplus \bar{C}}$$

et si B = 1 le transistor T52 est bloqué et en C50 on a un niveau qui dépend du résultat

$$\overline{A \oplus \bar{C}}$$

Le circuit 51 comprend trois transistors T53, T54, T55 et deux diodes Schottky D54 et D55. Les transistors T54 et T55 associés aux diodes D54 et D55 et aux résistances R53, R54, R55 sont montés de la même façon que dans le circuit de la figure 4 : le transistor T54 recevant sur son émetteur A, et le transistor T55 recevant C.

En conséquence il fournit au nœud C51 pris aux collecteurs communs des transistors T54 et T55 le résultat de la fonction

$$\overline{A \oplus C}$$

Le transistor T53 reçoit sur sa base le signal B, a son émetteur à la masse et son collecteur connecté au nœud C51.

Il permet d'obtenir à ce nœud le résultat de la fonction

$$\bar{B} \; \overline{(A \oplus C)}$$

En effet si B = 0 le transistor T53 et bloqué et en C50 on a un niveau qui dépend du résultat

$$\overline{A \oplus C}$$

Par contre si B = 1 le transistor T53 est conducteur et le niveau en C51 est bas quels que soient les résultats de $\overline{A \oplus C}$.

Le circuit 52 comprenant les transistors T56 et T57 ayant leurs collecteurs reliés ensemble à la sortie S, leurs émetteurs reliés à la masse et les collecteurs communs connectés à la tension de polarisation VP par la résistance, R57 permet d'obtenir en S le résultat de la fonction :

$$\overline{B \; \overline{(A \oplus \bar{C})}} + \overline{\bar{B} \; \overline{(A \oplus C)}}$$

Ce circuit OU exclusif à trois entrées est très simple. Il ne comprend que peu d'éléments et en conséquence ne prend que très peu de place. Il est très rapide, car sa vitesse correspond dans le pire des cas à la commutation de deux transistors en cascade. En utilisant une puissance suffisante (1, 6 mW), on obtient un délai de l'ordre de 2 ns.

Dans un mode de réalisation préféré, les résistances ont les valeurs suivantes :

R40 = R41 = R50 = R51 = R54 = R55 = R56 = 11 kilo-ohms
R43 = R52 = R53 = 4 kilo-ohms
R43 = R57 = 8 kilo-ohms

Sur la figure 6 on a représenté un générateur de valeur vraie/complémentaire qui peut être avantageusement utilisé comme circuit 32 de la figure 3.

Il comprend trois transistors T60, T61 et T62 le signal B5 est appliqué à l'émetteur du transistor T60, qui a sa base connectée à la tension de polarisation VP par une résistance R60 et son collecteur connecté à la base du transistor T61 d'une part et à la tension VP par une résistance R61 d'autre part.

L'émetteur du transistor T61 est connecté à la masse, son collecteur est connecté d'une part à la tension VP par une résistance R62 et d'autre part à la sortie $\bar{C}$ et à la base du transistor T62. L'émetteur du transistor T62 est connecté à la masse, son collecteur connecté à la tension VP par la résistance R63 et à la sortie C.

Le fonctionnement du circuit est le suivant :

Si B5 est au niveau bas : 0, le transistor T60 est conducteur, donc le transistor T61 est bloqué et le niveau en $\bar{C}$ est haut donc le complément de B5, le transistor T62 est conducteur donc le niveau en C est bas : 0.

Si B5 est au niveau haut 1, le transistor T60 est bloqué, donc le transistor T61 est conducteur et le transistor T62 est bloqué, le niveau en $\bar{C}$ est bas : 0 et le niveau en C est haut : 1.

Le circuit représenté sur la figure 3 peut être utilisé pour générer le bit de parité ; pour cela, il suffit de

7

mettre le bit B5 à 0 ou à 1, et d'appliquer les 8 bits de l'octet aux autres entrées. Le choix de mettre B5 à 0 ou à 1 dépend uniquement de la phase désirée en sortie. Ceci permet de n'utiliser qu'un type de circuits pour réaliser le générateur de bit de parité, et le circuit de vérification de parité.

Il est cependant évident que l'on peut réaliser facilement un circuit générateur de bit de parité en n'utilisant que les quatre circuits OU exclusifs d'entrée 30, 31, 33 et 34, les circuits 35 et 36, et en remplaçant le circuit 37 par un circuit identique à celui représenté sur la figure 4.

## Revendications

1. Circuit OU exclusif comportant deux bornes d'entrée (1 et 2) sur lesquels sont appliqués des signaux binaires A et B et une borne de sortie (3) sur laquelle est généré le résultat de la fonction $A \oplus B$, caractérisé en ce qu'il comprend :
un générateur (4) fournissant en sortie une tension de référence,
un premier circuit ayant deux bornes d'entrée qui sont les bornes d'entrée du circuit OU exclusif et une borne de sortie (C1) sur laquelle est généré le résultat de la fonction $\bar{A}\bar{B}$, comprenant une première et une seconde diodes (D1, D2) ayant chacune une de leurs bornes connectée à une des bornes d'entrée, et un premier et second transistors (T1, T2) ayant leurs émetteurs connectés à la sortie du générateur de tension de référence, leurs collecteurs reliés à la sortie (C1) dudit premier circuit, chacune des bases étant connectée à l'autre borne de chacune des diodes respectivement,
un second circuit ET (T4, T5) à deux entrées connectées aux bornes d'entrée (1 et 2) du circuit OU exclusif, et une sortie (C2) sur laquelle est généré le résultat de la fonction logique A.B,
un circuit de sortie NON OU (T3, T6) ayant deux entrées connectées aux sorties des deux premier et second circuits et une sortie constituant la borne de sortie (3) du circuit OU exclusif.

2. Circuit OU exclusif selon la revendication 1 caractérisé en ce que le second circuit ET comprend deux transistors ayant leurs émetteurs connectés aux bornes d'entrée et leurs collecteurs connectés en commun à la borne de sortie (C2) dudit circuit ET.

3. Circuit OU exclusif selon la revendication 1 ou 2 caractérisé en ce que le troisième circuit NON OU comprend deux transistors (T3, T6) ayant leurs bases connectées aux bornes de sortie des premier et second circuits (C1, C2), et leurs, collecteurs connectés en commun à la borne de sortie du circuit OU exclusif.

4. Circuit OU exclusif comportant au moins trois bornes d'entrée (20, 21, 22) sur lesquelles sont appliqués des signaux binaires A, B, C et une borne de sortie sur laquelle est généré le résultat de la fonction OU exclusif des signaux d'entrée, caractérisé en ce qu'il comprend :
un générateur fournissant sur une borne de sortie (23) une tension de référence,
un premier circuit ayant au moins trois bornes d'entrée qui sont les entrées du circuit OU exclusif et une borne de sortie (C10) sur laquelle est généré le résultat de la fonction $\bar{A}.\bar{B}.\bar{C}...$ des signaux d'entrée, comprenant au moins trois diodes (D11, D12, D13) ayant chacune une de leur borne connectée à une des bornes d'entrée et au moins trois transistors (T11, T12, T13) ayant leurs émetteurs connectés à la sortie du générateur de tension de référence, leurs collecteurs connectés en commun à la sortie (C10) dudit premier circuit, et chacune des bases étant connectée à l'autre borne de chacune des diodes respectivement,
au moins trois seconds circuits ayant chacun au moins trois entrées connectées aux entrées du circuit OU exclusif et au moins trois sorties (C11, C12, C13) sur lesquelles sont générés les résultats des fonctions $\bar{A}BC...$, $A\bar{B}C...$, $AB\bar{C}...$,
un circuit de sortie NON OU (T23, T24, T25, T26) ayant au moins quatre entrées connectées aux sorties du premier circuit et des au moins trois seconds circuits, et une sortie constituant la borne de sortie (24) du circuit OU exclusif.

5. Circuit OU exclusif selon la revendication 4, caractérisé en ce que chaque second circuit comprend une diode (D14 ou D15 ou D16) dont une des bornes est connectée à une des bornes d'entrée, un premier transistor (T14 ou T17 ou T20) dont la base est connectée à l'autre borne de la diode et l'émetteur à la borne de sortie du générateur de tension de référence, et au moins deux seconds transistors (T15, T16 ou T18, T19 ou T21, T22) dont les émetteurs sont connectés aux autres bornes d'entrée et dont les collecteurs connectés en commun avec le collecteur du premier transistor constituent la borne de sortie de chacun desdits seconds circuits.

6. Circuit de vérification de parité d'un multiplet de 9 bits (B1 à B9) caractérisé en ce qu'il comprend :
un premier étage de circuits logiques comprenant quatre circuits OU exclusifs (30, 31, 33, 34) selon la revendication 1, 2 ou 3 recevant sur chacune de leurs entrées un des bits,
un deuxième étage de circuits logiques comportant deux circuits OU exclusifs (35, 36) le premier recevant en entrées les sorties des premiers et second circuits OU exclusifs du premier étage et le second recevant en entrées les sorties des troisième et quatrième circuits OU exclusifs du premier étage,
un troisième étage de circuits logiques comprenant un circuit OU exclusif (37) recevant en entrées, les sorties A et B des circuits OU exclusifs du second étage et le bit restant fournissant en sortie l'indication de la parité du multiplet.

7. Circuit selon la revendication 6 caractérisé en ce que les circuits OU exclusifs du second étage comprenant :

un moyen de comparaison comparant les signaux d'entrée est générant une sortie 1, si ces deux signaux n'ont pas la même valeur et une sortie 0 dans le cas contraire.

8. Circuit selon la revendication 6 ou 7 caractérisé en ce que le premier étage comprend un générateur de valeur vraie/complémentaire ayant une entrée recevant le bit restant et deux sorties fournissant la valeur vraie dudit bit C et la valeur complémentaire dudit bit $\bar{C}$.

9. Circuit selon la revendication 8 caractérisé en ce que le circuit OU exclusif du dernier étage comprend :

un premier circuit (50) ayant trois entrées recevant les signaux A, $\bar{C}$, B et une sortie (C50) sur laquelle est généré le résultat de la fonction

$$B \ \overline{(A \oplus \bar{C})},$$

un second circuit (51) ayant trois entrées recevant les signaux A, C, B et une sortie (C51) sur laquelle est généré le résultat de la fonction

$$\bar{B} \ \overline{(A \oplus C)},$$

un troisième circuit (52) NON OU ayant deux entrées connectées aux sorties des premier et second circuits et fournissant en sortie le résultat de la fonction $A \oplus B \oplus C$.

## Claims

1. An Exclusive OR circuit comprising two input terminals (1 and 2) to which binary signals A and B are applied and an output terminal (3) at which the result of the function $A \oplus B$ is generated, characterized in that it includes :

a generator (4) providing a reference voltage as its output,

a first circuit having two input terminals which are the input terminals of the Exclusive OR circuit and an output terminal (C1) at which the result of the function $\bar{A}B$ is generated, including a first and a second diodes (D1, D2) each of which has one of its terminals connected to one of the input terminals, and a first and a second transistors (T1, T2) having their emitters connected to the output of the reference voltage generator and their collectors connected to the output (C1) of said first circuit, each of the bases being connected to the other terminal of each diode, respectively ;

a second AND circuit (T4, T5) provided with two inputs connected to the input terminals (1 and 2) of the Exclusive OR circuit, and an output (C2) at which the result of the logic function A.B is generated,

a NOR output circuit (T3, T6) having two inputs connected to the outputs of the first and second circuits and an output constituting the output terminal (3) of the Exclusive OR circuit.

2. An Exclusive OR circuit according to claim 1, characterized in that the second AND circuit comprises two transistors which have their emitters connected to the input terminals and their collectors connected together to the output terminal (C2) of said AND circuit.

3. An Exclusive OR circuit according to claim 1 or 2, characterized in that the third NOR circuit comprises two transistors (T3, T6) which have their bases connected to the output terminals of the first and second circuits (C1, C2) and their collectors connected together to the output terminal of the Exclusive OR circuit.

4. An Exclusive OR circuit comprising at least three input terminals (20, 21, 22) to which binary signals A, B, C are applied and an output terminal at which the result of the Exclusive OR function of the input signals is generated, characterized in that it includes :

a generator providing a reference voltage at an output terminal (23),

a first circuit having at least three input terminals which are the inputs of the Exclusive OR circuit and an output terminal (C10) at which the result of the function $\bar{A}.\bar{B}.\bar{C}...$ of the input signals is generated, comprising at least three diodes (D11, D12, D13) each of which has one of its terminals connected to one of the input terminals and at least three transistors (T11, T12, T13) having their emitters connected to the output of the reference voltage generator, their collectors connected together to the output (C10) of said first circuit, and each of their bases connected to the other terminal of each diode, respectively,

at least three second circuits each of which has at least three inputs connected to the inputs of the Exclusive OR circuit and at least three outputs (C11, C12, C13) at which the results of the functions $\bar{A}BC...$, $A\bar{B}C...$, $AB\bar{C}...$, are generated,

a NOR output circuit (T23, T24, T25, T26) having at least four inputs connected to the outputs of the first circuit and of said at least three second circuits, and an output constituting the output terminal (24) of the Exclusive OR circuit.

5. An Exclusive OR circuit according to claim 4, characterized in that each second circuit comprises a diode (D14 or D15 or D16) one of whose terminals is connected to one of the input terminals, a first transistor (T14 or T17 or T20) which has its base connected to the other terminal of the diode and its emitter connected to the output terminal of the reference voltage generator. and at least two second transistors (T15, T16 or T18, T19 or T21, T22) whose emitters are connected to the other input terminals and whose collectors, connected together to the collector of the first transistor, constitute the output terminal of each of said second circuits ;

6. A circuit for checking the parity of a 9-bit (B1-B9) byte, characterized in that it includes :

a first stage of logic circuits comprising four Exclusive OR circuits (30, 31, 33, 34) according to claim 1, 2 or 3, each of whose inputs receives one of the bits,

a second stage of logic circuits comprising two Exclusive OR circuits (35, 36), the first of which receives as inputs the outputs of the first and second Exclusive OR circuits of the first stage, and the second of which receives as inputs the outputs of the third and fourth Exclusive OR circuits of the first stage,

a third stage of logic circuits comprising an Exclusive OR circuit (37) which receives as inputs the outputs A and B of the Exclusive OR circuits of the second stage and the remaining bit, and which provides an indication of the parity of the byte as its output.

7. A circuit according to claim 6, characterized in that the Exclusive OR circuits of the second stage include :

comparison means for comparing the input signals and for generating a 1 output if these two signals do not have the same value and a 0 output if they do.

8. A circuit according to claim 6 or 7, characterized in that the first stage includes a true/complement value generator which has an input receiving the remaining bit and two outputs supplying the true value, C, of said bit and the complement value, $\bar{C}$, thereof.

9. A circuit according to claim 8, characterized in that the Exclusive OR circuit in the last stage includes :

a first circuit (50) which has three inputs receiving the signals A. $\bar{C}$, B and an output (C50) at which the result of the function

$$B \; \overline{(A \oplus \bar{C})},$$

is generated,

a second circuit (51) which has three inputs receiving signals A, C, B and an output (C51) at which the result of the function

$$\bar{B} \; \overline{(A \oplus C)},$$

is generated,

a third NOR circuit (52) which has two inputs connected to the outputs of the first and second circuits and which provides the result of the function $A \oplus B \oplus C$ as its output.

**Ansprüche**

1. Exklusiv-Oder-Schaltung mit zwei Eingangsklemmen (1 und 2), an denen Binärsignale A und B angelegt werden, und einer Ausgangsklemme (3), an der das Ergebnis der Funktion $A \oplus B$ generiert wird, dadurch gekennzeichnet, dass es umfasst :

einen Generator (4) der am Ausgang eine Bezugsspannung bereitstellt,

eine erste Schaltung mit zwei Eingangsklemmen, die die Eingangsklemmen der Exklusiv-Oder-Schaltung sind, und einer Ausgangsklemme (C1), an der das Ergebnis der Funktion $\bar{A}\bar{B}$, generiert wird, mit einer ersten und einer zweiten Diode (D1, D2), von denen jeweils eine Klemme an eine der Eingangsklemmen gelegt ist, und einem ersten und einem zweiten Transistor (T1, T2), deren Emitter an den Ausgang des Bezugsspannungsgenerators gelegt sind, während ihre Collectoren mit dem Ausgang (C1) der besagten ersten Schaltung verbunden sind, wobei jede der Basen an die andere Klemme einer jeden der Dioden gelegt ist,

eine zweite Und-Schaltung (T4, T5) mit zwei Eingängen, die an die Eingangsklemmen (1 und 2) der Exklusiv-Oder-Schaltung gelegt sind, und einem Ausgang (C2), an dem das Ergebnis der logischen Funktion A.B generiert wird,

eine Nein-Oder-Ausgangsschaltung (T3, T6), deren beide Eingänge an die Ausgänge der ersten und der zweiten Schaltung gelegt sind, und einen Ausgang, der die Ausgangsklemme (3) der Exklusiv-Oder-Schaltung bildet.

2. Exklusiv-Oder-Schaltung gemäss Anspruch 1, dadurch gekennzeichnet, dass die zweite Und-Schaltung zwei Transistoren enthält, deren Emitter an die Eingangsklemmen und deren Collectoren gemeinsam an die Ausgangsklemme (C2) der besagten Und-Schaltung gelegt sind.

3. Exklusiv-Oder-Schaltung gemäss Anspruch 1 oder 2, dadurch gekennzeichnet, dass die dritte Nein-Oder-Schaltung zwei Transistoren (T3, T6) enthält, deren Basen an den Ausgangsklemmen der ersten und der zweiten Schaltung (C1, C2) und deren Collectoren gemeinsam an der Ausgangsklemme der Exklusiv-Oder-Schaltung angeschlossen sind.

4. Exklusiv-Oder-Schaltung mit mindestens drei Eingangsklemmen (20, 21, 22) an denen Binärsignale A, B, C angelegt werden, und einer Ausgangsklemme, an der das Ergebnis der exklusiven Oder-Funktion der Eingangssignale generiert wird, dadurch gekennzeichnet, dass sie enthält :

einen Generator, der an einer Ausgangsklemme (23) eine Bezugsspannung abgibt,

eine erste Schaltung mit mindestens drei Eingangsklemmen, die die Eingänge der Exklusiv-Oder-Schaltung sind, und einer Ausgangsklemme (C10), an der das Ergebnis der Funktion $\bar{A}.\bar{B}.\bar{C}$... der Eingangssignale generiert wird, mit mindestens drei Dioden (D11, D12, D13), von denen jeweils eine Klemme an eine der Eingangsklemmen angeschlossen ist, und mindestens drei Transistoren (T11, T12, T13), deren Emitter an den Ausgang des Bezugsspannungsgenerators gelegt sind, während ihre Collectoren gemeinsam an den Ausgang (C10) der besagten ersten Schaltung gelegt sind und jede der Basen mit der anderen Klemme einer jeden Diode verbunden ist,

mindestens drei zweite Schaltungen mit je mindestens drei Eingängen, die an die Eingänge der Exklusiv-Oder-Schaltung gelegt sind, und mindestens drei Ausgänge (C11, C12, C13), an denen die Ergebnisse der Funktionen $\bar{A}BC$..., $A\bar{B}C$..., $AB\bar{C}$..., generiert werden,

eine Nein-Oder-Ausgangsschaltung (T23, T24, T25, T26), von der mindestens vier Eingänge an die Ausgänge der ersten Schaltung und der mindestens drei zweiten Schaltungen gelegt sind, und einen Ausgang, der die Ausgangsklemme (24) der Exklusiv-Oder-Schaltung bildet.

5. Exklusiv-Oder-Schaltung gemäss Anspruch 4, dadurch gekennzeichnet, dass jede zweite Schaltung eine Diode (D14 oder D15 oder D16) enthält, deren eine Klemme an eine der Eingangsklemmen gelegt ist, einen ersten Transistor (T14 oder T17 oder T20), dessen Basis an die andere Klemme der Diode gelegt ist, während der Emitter an die Ausgangsklemme des Bezugsspannungsgenerators gelegt ist, und mindestens zwei zweite Transistoren (T15, T16 oder T18, T19 oder T21, T22) deren Emitter an die anderen Eingangsklemmen gelegt sind und deren Collectoren gemeinsam mit dem Collector des ersten Transistors die Ausgangsklemme einer jeden der besagten zweiten Schaltungen bilden.

6. Paritätsprüfungsschaltung eines Byte von 9 bit (B1 bis B9), dadurch gekennzeichnet, dass es umfasst :

eine erste Stufe logischer Schaltungen mit vier Exklusiv-Oder-Schaltungen (30, 31, 33, 34) gemäss Anspruch 1, 2 oder 3, die an jedem ihrer Eingänge eines der Bits aufnehmen,

eine zweite Stufe logischer Schaltungen mit zwei Exklusiv-Oder-Schaltungen (35, 36), von denen die erste an ihren Eingängen die Ausgänge der ersten und der zweiten Exklusiv-Oder-Schaltung und die zweite an den Eingängen die Ausgänge der dritten und vierten Exklusiv-Oder-Schaltung der ersten Stufe empfängt,

eine dritte Stufe logischer Schaltungen mit einer Exklusiv-Oder-Schaltung (37), die an den Eingängen die Ausgänge A und B der Exklusiv-Oder-Schaltung der zweiten Stufe empfängt, während das verbleibende Bit am Ausgang die Parität des Byte anzeigt.

7. Schaltung gemäss Anspruch 6, dadurch gekennzeichnet, dass die Exklusiv-Oder-Schaltungen der zweiten Stufe enthalten :

ein Vergleichsmittel, das die Eingangssignale vergleicht und einen Ausgang 1 generiert, wenn diese beiden Signale nicht den gleichen Wert aufweisen, und einen Ausgang 0, wenn das Gegenteil der Fall ist.

8. Schaltung gemäss Anspruch 6 oder 7, dadurch gekennzeichnet, dass die erste Stufe einen Generator des wahren/komplementären Wertes enthält, der einen Eingang besitzt, welcher das verbleibende Bit aufnimmt, und zwei Ausgänge, die den wahren Wert des besagten Bits C und den komplementären Wert des besagten Bits C liefern.

9. Schaltung gemäss Anspruch 8, dadurch gekennzeichnet, dass die Exklusiv-Oder-Schaltung der letzten Stufe umfasst :

eine erste Schaltung (50) mit drei Eingängen, die die Signale A, C, B empfangen, und einen Ausgang (C50) an dem das Ergebnis der Funktion

$$B \, \overline{(A \oplus \bar{C})}$$

generiert wird,

eine zweite Schaltung (51) mit drei Eingängen, die die Signale A, C, B empfangen, und einen Ausgang (C51), an dem das Ergebnis der Funktion

$$\bar{B} \, \overline{(A \oplus C)}$$

generiert wird,

eine dritte (52) Nein-Oder-Schaltung mit zwei Eingängen, die an die Ausgänge der ersten und zweiten Schaltung angeschlossen sind und am Ausgang das Ergebnis der Funktion $A \oplus B \oplus C$ liefern.

# FIG. 1

# FIG.2

# FIG.3

B1
B2
B3
B4
B5
B6
B7
B8
B9

30
31
32
33
34
35
36
37

A
B

c̄
c

S

# FIG.4

VP

R40  R42  R43

E1
T40
D41
D40
T41

R41

E2

A OU B

T43

T44

VP

# FIG.5

# FIG.6